# EUROPEAN PATENT SPECIFICATION

(11) **EP 2 871 485 B1**
(45) Date of publication and mention of the grant of the patent: **11.09.2019**
(21) Application number: 13816588.1
(22) Date of filing: 26.06.2013
(51) Int. Cl.: G01R 15/18, G01R 19/165

(54) **CURRENT DETECTION DEVICE**
STROMERKENNUNGSVORRICHTUNG
DISPOSITIF DE DÉTECTION DE COURANT

(30) Priority: 09.07.2012 JP 2012153728
(43) Date of publication of application: 13.05.2015
(73) Proprietor: Panasonic Intellectual Property Management Co., Ltd., Osaka-shi, Osaka 540-6207 (JP)
(72) Inventor: YOSHIDA, Hiroshi, Osaka-shi, Osaka 540-6207 (JP); KANDA, Masataka, Osaka-shi, Osaka 540-6207 (JP); KAGAWA, Takuya, Osaka-shi, Osaka 540-6207 (JP); OKADA, Kenji, Osaka-shi, Osaka 540-6207 (JP); NAKAMURA, Atsushi, Osaka-shi, Osaka 540-6207 (JP)
(74) Representative: Appelt, Christian W.
(86) International application number: PCT/JP2013/003979
(87) International publication number: WO 2014/010187

(56) References cited:
- JP-A- H03 218 475
- JP-A- S61 155 862
- JP-A- 2002 082 149
- US-A- 3 882 387
- US-A- 4 529 931
- US-A- 5 132 608
- US-A1- 2005 280 409

## Description

### TECHNICAL FIELD

The invention relates to a current detection device configured to detect current flowing through a conductor in a contactless manner.

### BACKGROUND ART

JP 2004-523909A (hereinafter referred to as Document 1) describes one kind of current detection devices. A conventional example described in Document 1 includes a transformer that has a probe core, a probe winding, a compensation core, a compensation winding, and the like. The probe winding is wound around the ring-shaped probe core, and the compensation winding is wound around both the probe core and the ring-shaped compensation core having a diameter larger than that of the probe core. A conductor, which is a measurement target, is disposed so as to pass through the probe core and the compensation core.

In this conventional example, the magnitude of current flowing through the conductor is detected by a known flux gate detection circuit. That is, this detection circuit includes a symmetry stage and an amplifier stage downstream from the former, and the symmetry stage is connected at an input side to the probe winding. Bipolar magnetization is induced in the probe core via the symmetry stage. In this stage, an output signal generated from the asymmetry of the voltage and/or current characteristics over time is amplified in the amplifier stage and is used for controlling the compensation winding. The output current of the amplifier stage is fed into the compensation winding across a resistor (e.g., leading to ground potential). In the regulated state, the field of this current in the compensation core and in the probe core compensates for the magnetic flux of the conductor. Then the output current of the amplifier stage and thus the voltage drop across the resistor are proportional to the primary current flowing through the conductor. Accordingly, the magnitude of current flowing through the conductor can be detected by measuring the voltage drop across the resistor.

However, there is a problem in that the conventional example described in Document 1 has a complicated structure and downsizing thereof is difficult, since the transformer is constituted by two cores (the probe core and the compensation core) and two windings (the probe winding and the compensation winding). Also, there is a problem in that, although the magnitude of AC current flowing through the conductor can be detected by detecting the voltage induced in the compensation winding, the excitation current flowing through the probe winding affects the accuracy of current detection. Furthermore, there is a problem in that the compensation core is magnetized when an excessive current flows through the conductor, and thereafter the accuracy of current detection thereafter is influenced.

US 5,132,608 describes a current measuring method in which a magnetic sensor is a torodial core having a conductor for carrying a current to be measured passing through the hollow portion of the toroid. A coil on the core is excited with an AC voltage such that the positive and negative voltages induced in the coil are equal in amplitude when the conductor is not carrying current. Current in the conductor generates a change in magnetic flux which change is measured by detecting the algebraic sum of the amplitudes of the positive and negative voltages. Simultaneously, the amplifier output is applied to the input side of the AC voltage or a second coil disposed in the magnetic sensor so as to establish a magnetic equilibrium. Current measuring apparatus according to this invention include two types of apparatus composed of hardware to which the above-mentioned current measuring method is applied.

### SUMMARY OF INVENTION

The present invention has been made in view of the above-described problems, and an object of the present invention is to provide a current detection device that is downsized compared with the conventional example and has the improved accuracy of current detection and the improved stability with respect to overcurrent.

A current detection device according to the present invention as defined by claim 1 includes: a core to be disposed in a vicinity of a conductor which is a detection target; a winding wound around the core; an excitation unit configured to apply an excitation signal, having a magnitude and a direction that change at a constant period, to the winding; a magnetic flux detection unit configured to detect a magnetic flux generated in the core due to current flowing through the conductor; and an adder unit configured to add a feedback signal for cancelling the magnetic flux, which is detected by the magnetic flux detection unit, to the excitation signal.

It is preferable that, in the current detection device, the excitation unit is configured to magnetically saturate the core by applying the excitation signal, having a waveform which is symmetric in positive and negative, to the winding, and the magnetic flux detection unit includes a comparator configured to compare the excitation signal (an output from the winding) with threshold values that have the same absolute value but different signs, and an averaging circuit configured to average an output of the comparator in time axis over one period of the excitation signal, and is configured to generate the feedback signal from an output of the averaging circuit.

It is preferable that, in the current detection device, the threshold values of the comparator are variable.

It is preferable that, in the current detection device, the excitation unit is configured to apply the excitation signal, having a waveform which is symmetric in positive and negative, to the winding, and the magnetic flux detection unit includes an effective value calculation circuit configured to calculate an effective value of the excitation signal (an output from the winding), and is configured to generate the feedback signal from the effective value calculated in the effective value calculation circuit.

It is preferable that, in the current detection device, the excitation unit is configured to apply the excitation signal, having a waveform which is symmetric in positive and negative, to the winding, and the magnetic flux detection unit includes an averaging circuit configured to average the excitation signal (an output from the winding) in time axis over one period of the excitation signal, and is configured to generate the feedback signal from an output of the averaging circuit.

It is preferable that, in the current detection device, the excitation unit is configured so that the timing at which the excitation signal takes a peak value approximately matches with the timing at which the core is magnetically saturated.

It is preferable that the current detection device further includes a detection unit configured to detect a level of the feedback signal.

It is preferable that, in the current detection device, the detection unit is connected between the magnetic flux detection unit and the adder unit.

It is preferable that the current detection device further includes a detection unit configured to detect an output level of the magnetic flux detection unit.

It is preferable that, in the current detection device, the detection unit is connected between the magnetic flux detection unit and ground.

It is preferable that the current detection device further includes a low pass filter that is connected between the magnetic flux detection unit and the detection unit.

It is preferable that, in the current detection device, the core is formed of soft magnetic material.

It is preferable that, in the current detection device, the core is formed in a ring shape through which the conductor passes.

It is preferable that, in the current detection device, the core is an assembly of detachable divided components.

It is preferable that, in the current detection device, the core is formed in a columnar shape.

The current detection device according to the present invention as defined by claim 1 includes: the magnetic flux detection unit configured to detect the magnetic flux generated in the core due to the current flowing through the conductor; and the adder unit configured to add a feedback signal to the excitation signal such that the magnetic flux detected by the magnetic flux detection unit is cancelled by the feedback signal, and accordingly has an effect that the size thereof can be reduced compared with the conventional example that includes two cores and two windings, and the accuracy of current detection and the stability with respect to overcurrent can be improved.

### BRIEF DESCRIPTION OF DRAWINGS

FIG. 1 is a circuit configuration diagram illustrating a current detection device;
FIGS. 2A to 2D are waveform diagrams for illustrating operations of the current detection device;
FIG. 3 includes an upper waveform diagram of a signal voltage (an excitation voltage) of an excitation signal, and a lower waveform diagram of a signal current (an excitation current) of the excitation signal of the current detection device;
FIGS. 4A to 4E are perspective views illustrating other configurations of the core in the current detection device;
FIG. 5 is a block diagram illustrating another current detection device;
FIG. 6 is a circuit configuration diagram illustrating a current detection device according to an embodiment of the present invention;
FIG. 7 is a circuit configuration diagram illustrating another current detection device; and
FIGS. 8A and 8B are block diagrams illustrating another configuration of an excitation unit in the current detection device.

### DESCRIPTION OF EMBODIMENTS

Hereinafter, examples of a current detection device will be described in detail with reference to the diagrams.

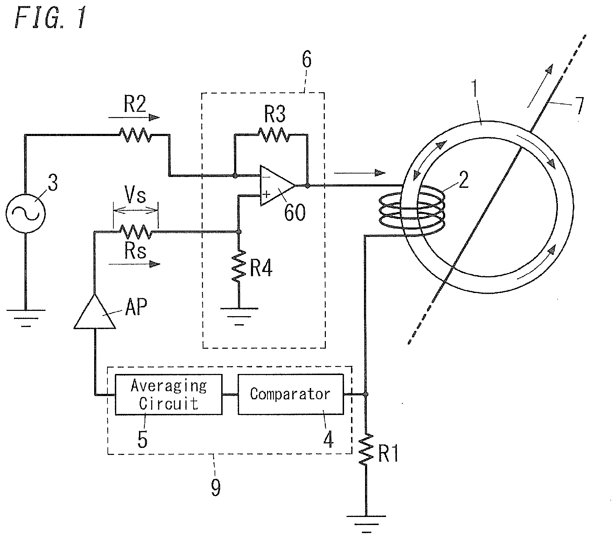

The current detection device according to one example includes a core 1, a winding 2 that is wound around the core 1, an excitation unit 3, a comparator 4, an averaging circuit 5, an adder unit 6, and the like, as shown in FIG. 1.

The core 1 is formed of soft magnetic material in a circular ring shape through which a conductor 7, as a detection target, passes. The soft magnetic material that forms the core 1 is preferably nanocrystal material, amorphous metal material (such as amorphous ribbon or amorphous wire), ferrite, magnetic fluid, or the like. The nanocrystal material and the amorphous metal material have an advantage that a hysteresis loop is maintained up to a high frequency, and the amorphous metal material is superior in strength over the nanocrystal material. Also, the ferrite has a feature that the cost is lower than the nanocrystal material and the amorphous metal material, and the magnetic fluid has a feature of not having hysteresis.

The winding 2 that is wound around the core 1 has one end connected to the adder unit 6 (an output end thereof) and the other end connected to ground via a resistor R1.

The excitation unit 3 is configured to output an excitation signal having a waveform of which the magnitude and direction change at a constant period and which is symmetric in positive and negative (such as sine wave, square wave, or triangular wave). The excitation unit 3 is configured to output an excitation voltage having a waveform which is symmetric in positive and negative. A positive electrode of the excitation unit 3 is connected to a first input end of the adder unit 6 via a current limiting resistor R2, and a negative electrode of the excitation unit 3 is grounded.

The comparator 4 is configured to compare threshold values that have the same absolute value but different signs with the excitation signal (a voltage drop across the resistor R1 that is proportional to the excitation signal, in actuality). That is, the comparator 4 is configured to compare the threshold values that have the same absolute value but different signs and the output from the winding 2. The comparator 4 is configured to compare the excitation signal (the output from the winding 2) with the threshold values ±Th. The comparator 4 is configured to output a high level (H) signal in a first period which is a period from a time point when the excitation signal rises to reach the threshold value Th to a time point when the excitation signal falls to reach the threshold value -Th after that, and a low level (L) signal in a second period which is a period from a time point when the excitation signal falls to reach the threshold value -Th to a time point when the excitation signal rises to reach the threshold value Th after that. The comparator 4 includes a window comparator, for example, and is configured to switch the output thereof between the high level and the low level at every falling edge of the output from the window comparator. The averaging circuit 5 is configured to calculate a time average of the output of the comparator 4 over a period of the excitation signal, and is constituted by an integration circuit, for example. The comparator 4 and the averaging circuit 5 constitute a magnetic flux detection unit 9 in the present embodiment. The output from the averaging circuit 5 is, after being amplified by an amplifier AP, inputted to a second input end of the adder unit 6 via the detection resistor Rs.

The adder unit 6 is constituted by an inverting amplifier that includes an operational amplifier 60, a feedback resistor R3, and an input resistor R4. The adder unit 6 is configured to add the output from the averaging circuit 5, which is inputted via the detection resistor Rs, to the excitation signal that is outputted from the excitation unit 3, and to output the added result to the winding 2.

Next, operations of the current detection device according to the present example will be described.

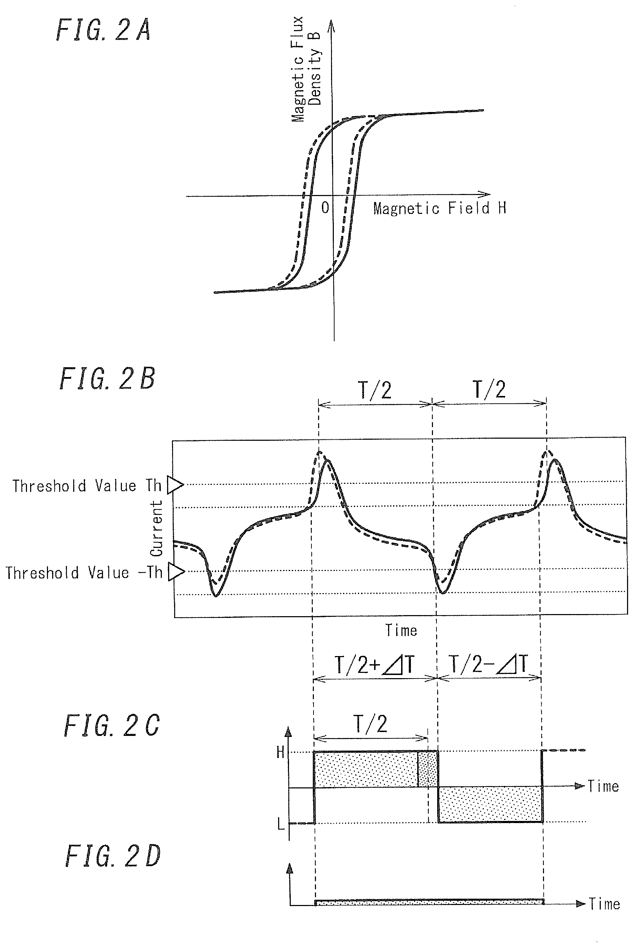

A magnetic flux (a magnetic field) is generated in the core 1 when the excitation signal (an excitation current) flows through the winding 2. The direction and magnitude of the magnetic flux change in synchronization with those of the excitation signal. That is, when no current flows through the conductor 7, the magnetic flux in the core 1 includes only the magnetic flux generated due to the excitation signal flowing through the winding 2, and therefore the magnetization characteristic (B-H characteristic) of the core 1 shows a loop that is point symmetrical relative to the origin, as shown by the solid line in FIG. 2A.

In this regard, the current detection device of the present embodiment adopts a flux gate magnetic flux detection method, and is configured to magnetically saturate the core 1 to rapidly change the excitation signal (the excitation current), and to detect the timing at which the excitation current changes rapidly by the comparator 4 (refer to the waveform shown by the solid line in FIG. 2B). With regard to a period T of the excitation signal, when no current flows through the conductor 7, a time period during which the output of the comparator 4 is the high level and a time period during which the output of the comparator 4 is the low level are both T/2,. Accordingly, the output of the averaging circuit 5 is zero, and nothing is added to the excitation signal.

On the other hand, when current flows through the conductor 7, a magnetic flux (a magnetic field) is generated in the core 1 that is arranged in the periphery of the conductor 7, where the direction of the magnetic flux follows the Ampere's law. Accordingly, the magnetization characteristic of the core 1 changes, and shows a loop that is not point symmetrical relative to the origin, as shown by the broken line in FIG. 2A. Therefore, a time period difference ΔT occurs between the time period during which the output of the comparator 4 is the high level and the time period during which the output thereof is the low level. In this case, for example, the time period during which the output of the comparator 4 is the high level is T/2+ΔT and the time period during which the output thereof is the low level is T/2-ΔT (refer to FIG. 2C). As a result, the output of the averaging circuit 5 is not zero, and takes a level according to the time difference ΔT (refer to FIG. 2D).

Then, the output of the averaging circuit 5, after being amplified in the amplifier AP, is added, in the adder unit 6, to the excitation signal that is outputted from the excitation unit 3. In this regard, the adder unit 6 is configured to invert the output of the averaging circuit 5, and then add the inverted result to the excitation signal that is outputted from the excitation unit 3. Therefore, the excitation signal is subjected to a feedback (negative feedback) that leads the time difference ΔT to zero, as a result of the addition of the output of the averaging circuit 5 to the excitation signal. Accordingly, by detecting the level of the output (the feedback signal) of the averaging circuit 5 as a voltage (a voltage drop) Vs across the detection resistor Rs when the time difference ΔT is considered to be zero, the magnitude of the current flowing through the conductor 7 can be calculated from the level of the feedback signal. Note that by making the threshold value Th of the comparator 4 variable, the sensitivity of current detection can be adjusted.

The output of the magnetic flux detection unit 9 (the output of the averaging circuit 5) is detected as the voltage (the voltage drop) Vs across the detection resistor (a detection unit) Rs. The current detection device according to the present example can detect DC current or AC current having a frequency that is of approximately the same order as the excitation signal (having a frequency that is smaller than the frequency of the excitation signal), flowing through the conductor 7.

As described above, the current detection device according to the present example includes the magnetic flux detection unit 9 (the comparator 4 and the averaging circuit 5) configured to detect the magnetic flux generated in the core 1 due to current flowing through the conductor 7, and the adder unit 6 configured to add the feedback signal to the excitation signal such that the magnetic flux detected in the magnetic flux detection unit 9 is cancelled. Accordingly, the current detection device can be downsized compared with the conventional example described in Document 1 (hereinafter referred to as the conventional example) that needs two cores and two windings, since the current detection device needs only one core and one winding. Also, the detection accuracy is decreased in the conventional example since excitation noise that is caused by the two windings being magnetically coupled is superimposed in the output. In contrast, the current detection accuracy can be improved in the current detection device according to the present example compared with the conventional example since only one winding 2 is included in the present example. Furthermore, unlike the conventional example, the present example does not include a core that is not magnetically saturated, and accordingly the stability with respect to an overcurrent of the current flowing through the conductor 7 can be improved compared with the conventional example.

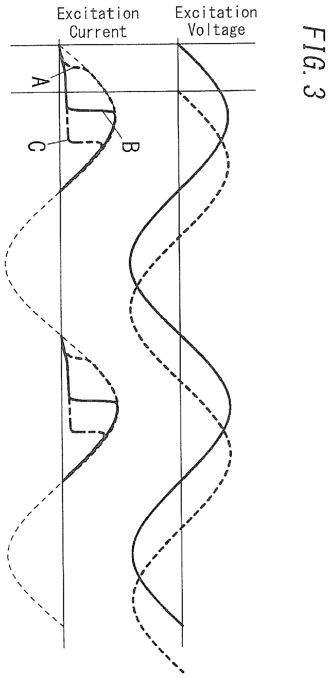

Incidentally, in order to improve the signal to noise ratio of the feedback signal by suppressing the influence of the noise component that is superimposed on the excitation signal, it is desirable that the timing at which the excitation signal (the excitation current) takes a peak value approximately matches with the timing at which the core 1 is magnetically saturated, as shown by the solid line B in the lower part of FIG. 3. According to this case, the variation amount of the excitation current increases compared with a case in which the timing at which the excitation current takes a peak value is earlier than the timing at which the core 1 is magnetically saturated (as shown by the broken line A in FIG. 3), and a case in which the timing at which the excitation current takes a peak value is later than the timing at which the core 1 is magnetically saturated (as shown by the dashed-dotted line C in FIG. 3). As a result, an erroneous determination due to the noise component is unlikely to occur when the comparator 4 performs the comparison with respect to the threshold values, resulting in an improvement in the signal to noise ratio of the feedback signal. In order to approximately match the timing at which the core 1 is magnetically saturated and the timing at which the excitation current takes a peak value, it is sufficient that the signal voltage of the excitation signal that is outputted from the excitation unit 3 or the number of turns of the winding 2 is adjusted according to the magnetization characteristic of the core 1.

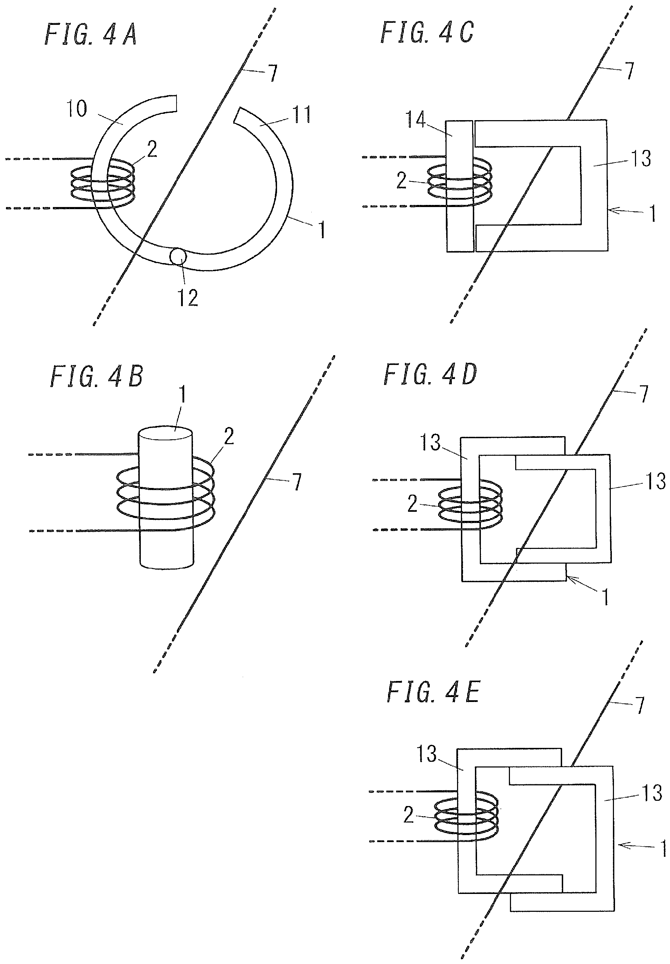

Here, it is preferable that the core 1 is divided into two semi-circular portions 10 and 11, as shown in FIG. 4A, ends of the portions 10 and 11 on one side are rotatably coupled by a shaft 12, and the other ends (free ends) of the portions 10 and 11 on the other side are detachable from each other. The conductor 7, as a detection target, can be easily passed through the core 1 having such a structure.

Alternatively, the core 1 may be formed in a columnar shape (a circular cylinder, for example), as shown in FIG. 4B. The winding 2 can be easily wound around the core 1 having such a columnar shape.

Also, the shape of the core 1 is not limited to a circular ring, and the core 1 may have a rectangular frame shape in which a substantially C-shaped (a bracket-shaped) core 13 and an I-shaped core 14 are combined, as shown in FIG. 4C, for example. Alternatively, the core 1 may be configured by combining two substantially C-shaped cores 13, as shown in FIGS. 4D and 4E.

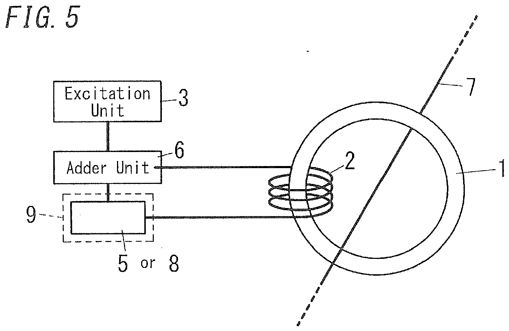

Incidentally, in the above example, the case where the magnetic flux detection unit 9 is constituted by the comparator 4 and the averaging circuit 5 was taken as an example. However, a magnetic flux detection unit 9 may be constituted by only an averaging circuit 5 configured to calculate a time average of an excitation signal over a period of the excitation signal, as shown in FIG. 5. In this case, a feedback signal may be generated from the output of the averaging circuit 5. Alternatively, a magnetic flux detection unit 9 may be constituted by an effective value calculation circuit 8 configured to calculate an effective value of an excitation signal, instead of the averaging circuit 5. In this case, a feedback signal may be generated from the effective value that is calculated by the effective value calculation circuit 8. Since the effective value calculation circuit 8 can be realized by a known technique, detailed illustration and description of the circuit configuration thereof will be omitted.

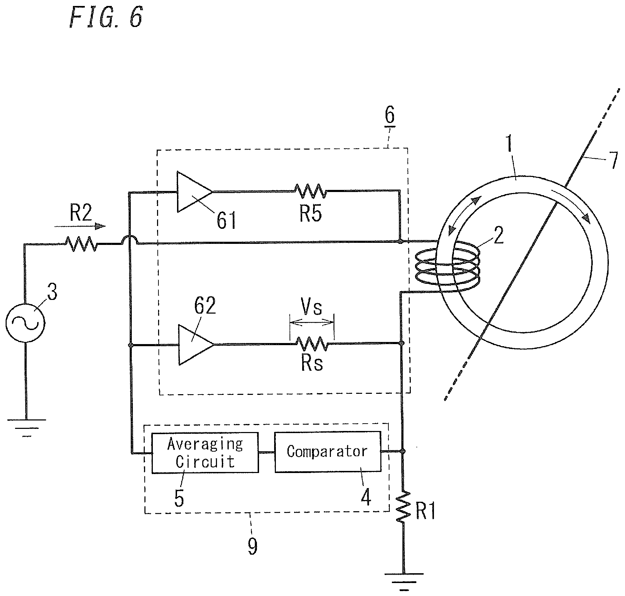

Also, the configuration of the adder unit 6 is not limited to the inverting amplifier including the operational amplifier 60. For example, according to the invention as defined by claim 1 an adder unit 6 includes two amplifiers 61 and 62 of which respective output ends are bridge-connected via a winding 2, as shown in FIG. 6. In this example, a resistor R5 is connected to an output end of one amplifier 61, and a detection resistor Rs is connected to an output end of the other amplifier 62. Accordingly, the outputs (feedback signals) of the amplifiers 61 and 62 are added to the excitation signal via the resistor R5 and the detection resistor Rs, respectively, and the resultant signal is applied to the winding 2. According to such a circuit configuration, there is an advantage that the output voltage of the adder unit 6 is doubled compared with a case of one amplifier.

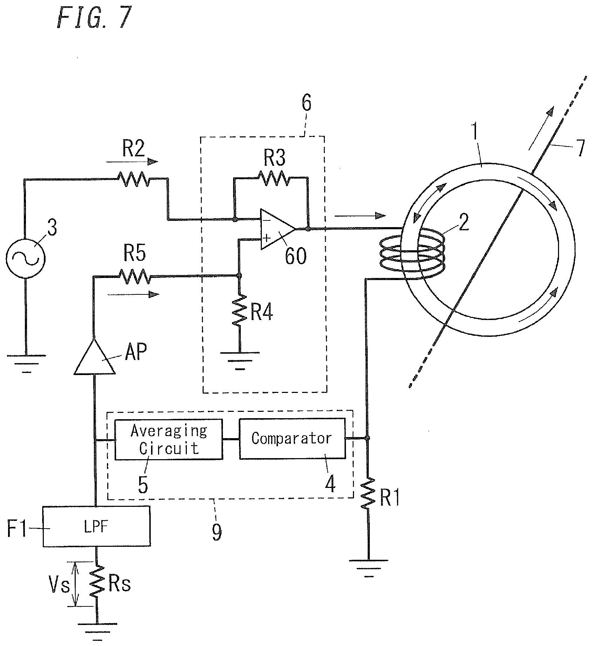

Also, the detection resistor Rs (a detection unit) may be connected between the magnetic flux detection unit 9 and ground, as shown in FIG. 7. The output of the magnetic flux detection unit 9 is, after being amplified by the amplifier AP, inputted to a second input end of the adder unit 6 via a resistor R5.

Also, it is preferable that a low pass filter F1 is disposed between a magnetic flux detection unit 9 and a detection resistor Rs (a detection unit). By the low pass filter F1 provided on an input side of the detection resistor Rs, a high frequency noise component is reduced, and as a result, the accuracy of detection of the output from the magnetic flux detection unit 9 can be improved.

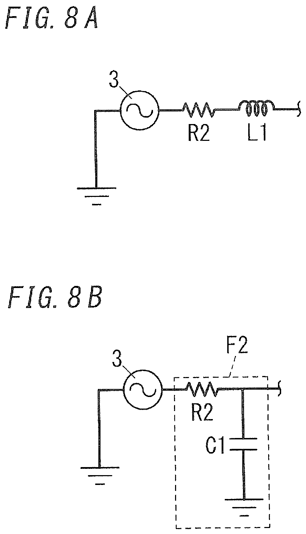

Also, as shown in FIGS. 8A and 8B, an impedance element (an inductor L1) or a low pass filter F2 (a resistor R2 connected in series to an excitation unit 3 and a capacitor C1 connected in parallel to the excitation unit 3) may be provided between the excitation unit 3 and an adder unit 6. According to such a configuration, in the case where the excitation signal is a square wave or the like, the waveform of the excitation signal is rounded by removing a high frequency component thereof, and as a result, a sharp change of the excitation signal can be eliminated and noise generated in the adder unit 6 and the like can be reduced.

## Claims

1. A current detection device comprising:
a core (1) to be disposed in a vicinity of a conductor (7) as a detection target;
a winding (2) wound around the core;
an excitation unit (3) configured to apply an excitation signal, having a magnitude and a direction that change at a constant period, to the winding (2);
a magnetic flux detection unit (9) configured to detect a magnetic flux generated in the core (1) due to current flowing through the conductor (7); and
an adder unit (6) configured to add a feedback signal to the excitation signal such that the magnetic flux detected by the magnetic flux detection unit (9) is cancelled, wherein the feedback signal is generated from an output of the magnetic flux detection unit (9),
**characterized by**
the adder unit (6) comprising two amplifiers (61, 62) of which respective output ends are bridge-connected via the winding (2).

2. The current detection device according to claim 1, wherein
the excitation unit (3) is configured to magnetically saturate the core (1) by applying the excitation signal, having a waveform which is symmetric in positive and negative, to the winding (2), and
the magnetic flux detection unit (9) comprises a comparator (4) configured to compare the excitation signal with threshold values that have the same absolute value but different signs, and an averaging circuit (5) configured to calculate a time average of an output of the comparator (4) over the period of the excitation signal, and is configured to generate the feedback signal from an output of the averaging circuit (5).

3. The current detection device according to claim 2, wherein the threshold values of the comparator (4) are variable.

4. The current detection device according to claim 1, wherein
the excitation unit (3) is configured to apply the excitation signal, having a waveform which is symmetric in positive and negative, to the winding (2), and
the magnetic flux detection unit (9) comprises an effective value calculation circuit (8) configured to calculate an effective value of the excitation signal, and is configured to generate the feedback signal from the effective value calculated in the effective value calculation circuit (8).

5. The current detection device according to claim 1, wherein
the excitation unit (3) is configured to apply the excitation signal, having a waveform which is symmetric in positive and negative, to the winding (2), and
the magnetic flux detection unit (9) comprises an averaging circuit (5) configured to calculate a time average of the excitation signal over the period of the excitation signal, and is configured to generate the feedback signal from an output of the averaging circuit (5).

6. The current detection device according to any one of claims 2 to 5, wherein the excitation unit (3) is configured so that the timing at which the excitation signal takes a peak value approximately matches with the timing at which the core (1) is magnetically saturated.

7. The current detection device according to any one of claims 1 to 6, further comprising a detection unit (Rs) configured to detect a level of the feedback signal.

8. The current detection device according to claim 7, wherein the detection unit is connected between the magnetic flux detection unit (9) and the adder unit (6).

9. The current detection device according to any one of claims 1 to 6, further comprising a detection unit (Rs) configured to detect an output level of the magnetic flux detection unit (9).

10. The current detection device according to claim 9, wherein the detection unit (Rs) is connected between the magnetic flux detection unit (9) and ground.

11. The current detection device according to claim 10, further comprising a low pass filter (F1) that is connected between the magnetic flux detection unit (9) and the detection unit (3).

12. The current detection device according to any one of claims 1 to 11, wherein the core (1) is formed of soft magnetic material.

13. The current detection device according to any one of claims 1 to 12, wherein the core (1) is formed in a ring shape through which the conductor (7) passes.

14. The current detection device according to claim 13, wherein the core (1) is an assembly of detachable divided components.

15. The current detection device according to any one of claims 1 to 12, wherein the core (1) is formed in a columnar shape.

## Patentansprüche

1. Stromdetektiervorrichtung, umfassend:
einen Kern (1), der in einer Nähe eines Leiters (7) als Detektierziel anzuordnen ist;
eine um den Kern gewickelte Wicklung (2);
eine Erregungseinheit (3), die dazu ausgebildet ist, ein Erregungssignal an die Wicklung (2) anzulegen, das eine Größe und eine Richtung aufweist, die sich mit einer konstanten Periode ändern;
eine Magnetflussdetektiereinheit (9), die dazu ausgebildet ist, einen magnetischen Fluss zu detektieren, der aufgrund von Strom, der durch den Leiter (7) fließt, in dem Kern (1) erzeugt wird; und
eine Addierereinheit (6), die dazu ausgebildet ist, zu dem Erregungssignal ein Rückkopplungssignal hinzuzuaddieren, derart, dass der durch die Magnetflussdetektiereinheit (9) detektierte magnetische Fluss aufgehoben wird, wobei das Rückkopplungssignal von einem Ausgang der Magnetflussdetektiereinheit (9) erzeugt wird,
**dadurch gekennzeichnet, dass**
die Addierereinheit (6) zwei Verstärker (61, 62) umfasst, von denen jeweilige Ausgangsenden über die Wicklung (2) in Brücke geschaltet sind.

2. Stromdetektiervorrichtung nach Anspruch 1, wobei die Erregungseinheit (3) dazu ausgebildet ist, durch Anlegen des Erregungssignals an die Wicklung (2), das eine Wellenform aufweist, die im Positiven und Negativen symmetrisch ist, den Kern (1) magnetisch zu sättigen, und die Magnetflussdetektiereinheit (9) einen Komparator (4), der dazu ausgebildet ist, das Erregungssignal mit Schwellenwerten zu vergleichen, die denselben Absolutwert jedoch andere Vorzeichen aufweisen, und eine Mittelwertbildungsschaltung (5), die dazu ausgebildet ist, einen Zeitmittelwert eines Ausgangs des Komparators (4) über die Periode des Erregungssignals zu berechnen, umfasst und dazu ausgebildet ist, das Rückkopplungssignal aus einem Ausgang der Mittelwertbildungsschaltung (5) zu erzeugen.

3. Stromdetektiervorrichtung nach Anspruch 2, wobei die Schwellenwerte des Komparators (4) variabel sind.

4. Stromdetektiervorrichtung nach Anspruch 1, wobei die Erregungseinheit (3) dazu ausgebildet ist, das Erregungssignal, das eine Wellenform aufweist, die im Positiven und Negativen symmetrisch ist, an die Wicklung (2) anzulegen, und
die Magnetflussdetektiereinheit (9) eine Effektivwertberechnungsschaltung (8), die dazu ausgebildet ist, einen Effektivwert des Erregungssignals zu berechnen, umfasst und dazu ausgebildet ist, das Rückkopplungssignal aus dem Effektivwert, der in der Effektivwertberechnungsschaltung (8) berechnet wird, zu erzeugen.

5. Stromdetektiervorrichtung nach Anspruch 1, wobei die Erregungseinheit (3) dazu ausgebildet ist, das Erregungssignal, das eine Wellenform aufweist, die im Positiven und Negativen symmetrisch ist, an die Wicklung (2) anzulegen, und
die Magnetflussdetektiereinheit (9) eine Mittelwertbildungsschaltung (5), die dazu ausgebildet ist, einen Zeitmittelwert des Erregungssignals über die Periode des Erregungssignals zu berechnen, umfasst und dazu ausgebildet ist, das Rückkopplungssignal aus einem Ausgang der Mittelwertbildungsschaltung (5) zu erzeugen.

6. Stromdetektiervorrichtung nach einem beliebigen der Ansprüche 2 bis 5, wobei die Erregungseinheit (3) so ausgebildet ist, dass der Zeitpunkt, zu dem das Erregungssignal einen Spitzenwert annimmt, ungefähr dem Zeitpunkt entspricht, zu dem der Kern (1) magnetisch gesättigt ist.

7. Stromdetektiervorrichtung nach einem beliebigen der Ansprüche 1 bis 6, ferner umfassend eine Detektiereinheit (Rs), die dazu ausgebildet ist, einen Pegel des Rückkopplungssignals zu detektieren.

8. Stromdetektiervorrichtung nach Anspruch 7, wobei die Detektiereinheit zwischen der Magnetflussdetektiereinheit (9) und der Addierereinheit (6) geschaltet ist.

9. Stromdetektiervorrichtung nach einem beliebigen der Ansprüche 1 bis 6, ferner umfassend eine Detektiereinheit (Rs), die dazu ausgebildet ist, einen Ausgangspegel der Magnetflussdetektiereinheit (9) zu detektieren.

10. Stromdetektiervorrichtung nach Anspruch 9, wobei die Detektiereinheit (Rs) zwischen der Magnetflussdetektiereinheit (9) und der Erde geschaltet ist.

11. Stromdetektiervorrichtung nach Anspruch 10, ferner umfassend ein Tiefpassfilter (F1), das zwischen der Magnetflussdetektiereinheit (9) und der Detektiereinheit (3) geschaltet ist.

12. Stromdetektiervorrichtung nach einem beliebigen der Ansprüche 1 bis 11, wobei der Kern (1) aus weichmagnetischem Material gebildet ist.

13. Stromdetektiervorrichtung nach einem beliebigen der Ansprüche 1 bis 12, wobei der Kern (1) in einer Ringform, durch welche der Leiter (7) verläuft, ausgebildet ist.

14. Stromdetektiervorrichtung nach Anspruch 13, wobei der Kern (1) eine Anordnung aus abnehmbaren, getrennten Komponenten ist.

15. Stromdetektiervorrichtung nach einem beliebigen der Ansprüche 1 bis 12, wobei der Kern (1) in einer Säulenform ausgebildet ist.

## Revendications

1. Dispositif de détection de courant comprenant :
un noyau (1) à disposer dans le voisinage d'un conducteur (7) en tant que cible de détection ;
un enroulement (2) enroulé autour du noyau ;
une unité d'excitation (3) configurée pour appliquer un signal d'excitation, ayant une amplitude et une direction qui changent avec une période constante, à l'enroulement (2) ;
une unité de détection de flux magnétique (9) configurée pour détecter un flux magnétique généré dans le noyau (1) du fait d'un courant circulant à travers le conducteur (7) ; et
une unité d'additionneur (6) configurée pour ajouter un signal de rétroaction au signal d'excitation de sorte que le flux magnétique détecté par l'unité de détection de flux magnétique (9) soit annulé, dans lequel le signal de rétroaction est généré à partir d'une sortie de l'unité de détection de flux magnétique (9), **caractérisé par**
l'unité d'additionneur (6) comprenant deux amplificateurs (61, 62) dont les extrémités de sortie respectives sont connectées en pont par l'intermédiaire de l'enroulement (2).

2. Dispositif de détection de courant selon la revendication 1, dans lequel
l'unité d'excitation (3) est configurée pour saturer magnétiquement le noyau (1) en appliquant le signal d'excitation, ayant une forme d'onde qui est symétrique en positif et négatif, à l'enroulement (2), et
l'unité de détection de flux magnétique (9) comprend un comparateur (4) configuré pour comparer le signal d'excitation avec des valeurs de seuil qui ont la même valeur absolue mais des signes différents, et un circuit de moyennage (5) configuré pour calculer une moyenne temporelle d'une sortie du comparateur (4) sur la période du signal d'excitation, et est configurée pour générer le signal de rétroaction à partir d'une sortie du circuit de moyennage (5).

3. Dispositif de détection de courant selon la revendication 2, dans lequel les valeurs de seuil du comparateur (4) sont variables.

4. Dispositif de détection de courant selon la revendication 1, dans lequel
l'unité d'excitation (3) est configurée pour appliquer le signal d'excitation, ayant une forme d'onde qui est symétrique en positif et négatif, à l'enroulement (2), et
l'unité de détection de flux magnétique (9) comprend un circuit de calcul de valeur efficace (8) configuré pour calculer une valeur efficace du signal d'excitation, et est configurée pour générer le signal de rétroaction à partir de la valeur efficace calculée dans le circuit de calcul de valeur efficace (8).

5. Dispositif de détection de courant selon la revendication 1, dans lequel
l'unité d'excitation (3) est configurée pour appliquer le signal d'excitation, ayant une forme d'onde qui est symétrique en positif et négatif, à l'enroulement (2), et
l'unité de détection de flux magnétique (9) comprend un circuit de moyennage (5) configuré pour calculer une moyenne temporelle du signal d'excitation sur la période du signal d'excitation, et est configurée pour générer le signal de rétroaction à partir d'une sortie du circuit de moyennage (5).

6. Dispositif de détection de courant selon l'une quelconque des revendications 2 à 5, dans lequel l'unité d'excitation (3) est configurée de sorte que l'instant auquel le signal d'excitation prend une valeur crête corresponde à peu près à l'instant auquel le noyau (1) est saturé magnétiquement.

7. Dispositif de détection de courant selon l'une quelconque des revendications 1 à 6, comprenant en outre une unité de détection (Rs) configurée pour détecter un niveau du signal de rétroaction.

8. Dispositif de détection de courant selon la revendication 7, dans lequel l'unité de détection est connectée entre l'unité de détection de flux magnétique (9) et l'unité d'additionneur (6).

9. Dispositif de détection de courant selon l'une quelconque des revendications 1 à 6, comprenant en outre une unité de détection (Rs) configurée pour détecter un niveau de sortie de l'unité de détection de flux magnétique (9).

10. Dispositif de détection de courant selon la revendication 9, dans lequel l'unité de détection (Rs) est connectée entre l'unité de détection de flux magnétique (9) et la masse.

11. Dispositif de détection de courant selon la revendication 10, comprenant en outre un filtre passe-bas (F1) qui est connecté entre l'unité de détection de flux magnétique (9) et l'unité de détection (3).

12. Dispositif de détection de courant selon l'une quelconque des revendications 1 à 11, dans lequel le noyau (1) est constitué d'un matériau magnétique doux.

13. Dispositif de détection de courant selon l'une quelconque des revendications 1 à 12, dans lequel le noyau (1) est réalisé en une forme annulaire à travers laquelle le conducteur (7) passe.

14. Dispositif de détection de courant selon la revendication 13, dans lequel le noyau (1) est un ensemble de composants divisés détachables.

15. Dispositif de détection de courant selon l'une quelconque des revendications 1 à 12, dans lequel le noyau (1) est réalisé en une forme de colonne.
